# EUROPEAN PATENT APPLICATION

(11) **EP 1 480 280 A2**
(43) Date of publication of application: **24.11.2004**
(21) Application number: 04011981.0
(22) Date of filing: 19.05.2004
(51) Int. Cl.: H01L 51/20

(54) **Organic electroluminescent device and method for manufacturing the same**

(30) Priority: 23.05.2003 JP 2003145553
(71) Applicant: Kabushiki Kaisha Toyota Jidoshokki, Kariya-shi, Aichi-ken (JP)
(72) Inventor: Hieda, Masato, Kariya-shi Aichi-ken (JP)
(74) Representative: Leson, Thomas Johannes Alois, Dipl.-Ing.

(57) **Abstract**

An organic EL device having uniform brightness. The organic EL device includes two electrodes (1, 4), one of which is transparent. An organic layer (3) including organic electroluminescent material is arranged between the two electrodes. The organic layer emits light that exits from the transparent electrode. An auxiliary electrode (4) is arranged between the transparent electrode and the organic layer. The auxiliary electrode has resistivity that is less than that of the transparent electrode and includes a first surface that is in contact with the transparent electrode and a second surface that does not contact the transparent electrode and has been plasma-treated.

## Description

The present invention relates to an organic electroluminescent device that has an organic layer, which includes an organic luminescent material, arranged between a pair of electrodes, one of which is transparent, to externally emit light generated by the organic layer from the transparent electrode.

An organic electroluminescent (organic EL) device has an organic layer, which includes an organic luminescent material, arranged between a pair of electrodes. When current flows between the electrodes, holes (positive holes) and electrons are recombined to generate excitons. This excites the organic luminescent material. When returning to the ground state, the organic luminescent material emits electroluminescence (light). Accordingly, the organic electroluminescent device is a self-luminescent device.

In such an organic EL device, the light emitted by the organic layer is output from one of the electrodes.
Accordingly, a transparent electrode (transparent conductive layer) is used as the electrode that is located at the light exiting side of the organic layer.

However, a typical transparent electrode has high resistance. This increases the power consumption of the organic EL device.

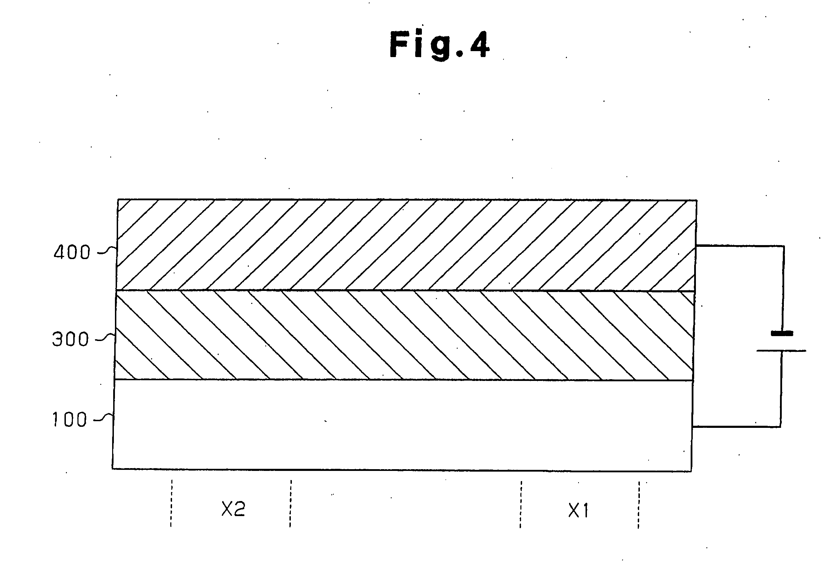

Further, referring to Fig. 4, a potential difference is produced in the transparent electrode 100 between a portion X1 located near a terminal and a portion (e.g., X2) separated from the terminal. As a result, in an organic EL device, the amount of light, or luminance, of an organic layer 300 differs between portions X1 and X2. In other words, a luminance differences occur in the organic layer 300.

Japanese Laid-Open Patent Publication No. 11-339970 proposes a solution to this problem. Referring to Fig. 5, an organic layer 300 and an opposing electrode, which functions as a cathode (electron injection electrode), are superimposed on a transparent electrode 100, which functions as an anode (hole injection electrode, positive hole injection electrode). The organic layer 300 includes one layer or a plurality of superimposed layers that include organic luminescent material. An auxiliary electrode 200 having resistivity that is less than that of the transparent electrode 100 is superimposed on part of the transparent electrode 100 and electrically connected to the transparent electrode 100.

The low resistivity transparent electrode 100 arranged on the auxiliary electrode 200 decreases potential differences in the plane of the transparent electrode 100 in comparison to when there is no auxiliary electrode. This prevents the occurrence of luminance differences. In other words, the difference in luminance and the luminance ratio between portions X1 and X2 is decreased.

However, the distance between the transparent electrode 100 and the opposing electrode 400 (thickness) at where the auxiliary electrode 200 is located is less then that at other locations. This increases the luminance around the auxiliary electrode 200 in the light exiting side (light exiting surface) of the organic EL device. Further, bright spots appear in the light emission surface of the organic EL device around the auxiliary electrode 200. This is believed to occur because of leakage between the auxiliary electrode 200 and the opposing electrode 400 or because of the extreme proximity of the auxiliary electrode 200 and the opposing electrode 400. Accordingly, the technology proposed in the above publication does not essentially prevent the occurrence of luminance differences.

One aspect of the present invention is an organic electroluminescent device including two electrodes, at least one of which is transparent. An organic layer including organic electroluminescent material is arranged between the two electrodes. The organic layer is operable for emitting light that exits from the transparent electrode. An auxiliary electrode is arranged between the transparent electrode and the organic layer. The auxiliary electrode has resistivity that is less than that of the transparent electrode and includes a first surface that is in contact with the transparent electrode and a second surface that does not contact the transparent electrode and that has been plasma-treated.

A further aspect of the present invention is a method for manufacturing an electroluminescent device including two electrodes, at least one of which is transparent, and an organic layer arranged between the two electrodes. The method includes forming an auxiliary electrode on the transparent electrode. The auxiliary electrode has resistivity that is less than that of the transparent electrode and includes a first surface that is in contact with the transparent electrode and a second surface that does not contact the transparent electrode. The method further includes plasma-treating at least part of the second surface of the auxiliary electrode, and superimposing the organic layer and the other one of the electrodes on the transparent electrode and the auxiliary electrode.

Other aspects and advantages of the present invention will become apparent from the following description, taken in conjunction with the accompanying drawings, illustrating by way of example the principles of the invention.

The invention, together with objects and advantages thereof, may best be understood by reference to the following description of the presently preferred embodiments together with the accompanying drawings in which:
Fig. 1 is a cross-sectional view showing the structure of an organic EL device according to a preferred embodiment of the present invention;
Fig. 2 is a perspective view showing an auxiliary electrode in the organic EL device of Fig. 1;
Fig. 3 is a diagram showing the structure of the organic EL device in one example;
Fig. 4 is a cross-sectional view showing the structure of a first prior art example of an organic EL device; and

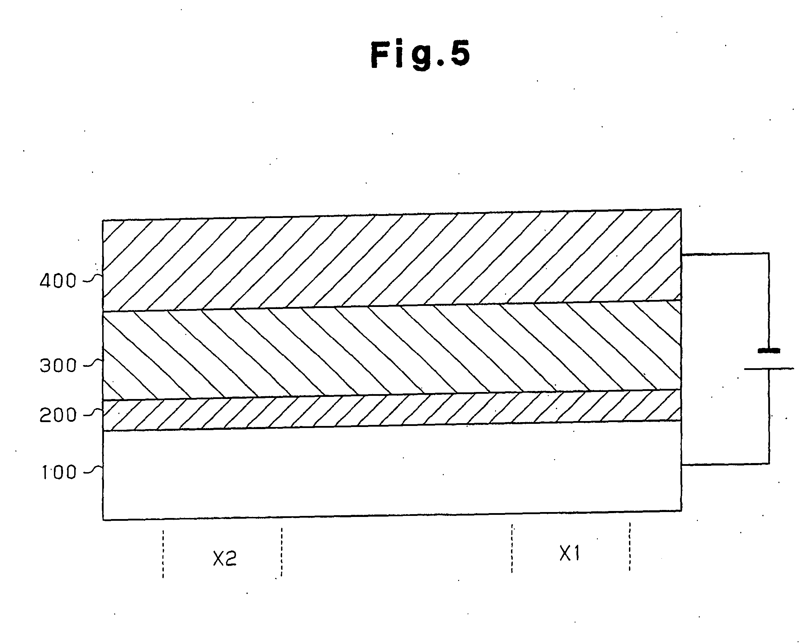

Fig. 5 is a cross-sectional view showing the structure of a second prior art example of an organic EL device.

An organic EL device according to a preferred embodiment of the present invention will now be discussed with reference to the drawings.

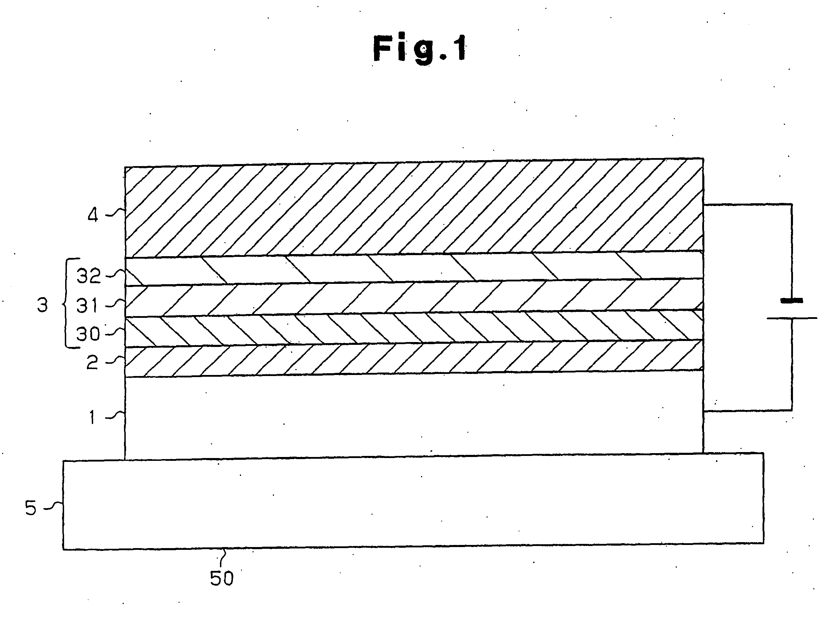

Referring to Fig. 1, the organic EL device of the preferred embodiment includes a transparent electrode 1. The transparent electrode 1 functions as an anode and is formed on a transparent substrate 5. Auxiliary electrodes 2 are formed on parts of the transparent electrode 1. An organic layer 3 including an organic luminescent material is formed on the transparent electrode 1 and the auxiliary electrodes 2. An opposing electrode 4 functioning as a cathode is formed on the organic layer 3. The organic layer 3 emits light when current flows between the transparent electrode 1 and the opposing electrode 4. The emitted light exits the organic EL device from a light exiting surface 50 defined on the transparent electrode 1. Plasma treatment is performed on the portions of the auxiliary electrodes 2 that are not in contact with the transparent electrode 1.

The auxiliary electrodes 2 and the transparent electrode 1 will now be discussed in detail.

### <Auxiliary Electrodes 2>

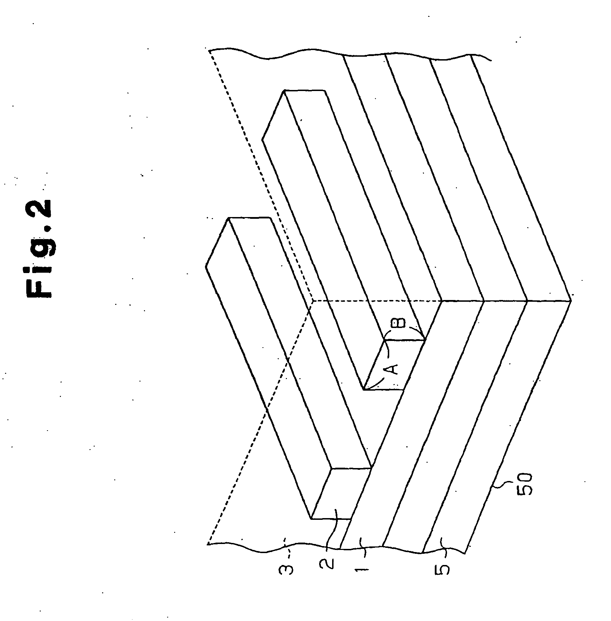

Referring to Fig. 2, the auxiliary electrodes 2 are formed on parts of the transparent electrode 1 (on the side of the organic layer 3, which is indicated by the broken lines). Each auxiliary electrode 2, which is a conductive layer having a resistivity that is less than that of the transparent electrode 1, is electrically connected to the transparent electrode 1. The employment of the auxiliary electrodes 2 has the effects described below.

The arrangement of the low resistivity auxiliary electrodes 2 on parts of the transparent electrode 1, which functions as the anode, decreases resistance of the anode as a whole.

The potential becomes uniform throughout the entire surface of the transparent electrode 1 when using the auxiliary electrodes 2. Thus, the amount of the generated light (luminance) becomes uniform.

The auxiliary electrodes 2 may be made of any material enabling the auxiliary electrodes 2 to have resistivity that is less than that of the transparent electrode 1. For example, the material may be selected from Al, Sc, Nb, Zr, Hf, Nd, Ta, Cu, Si, Cr, Mo, Mn, Ni, Pd, Pt, and W. The auxiliary electrodes 2 may be made of only one of these materials or an alloy obtained by mixing two or more of these materials. When using two or more of these materials, the materials may be mixed at any mixing ratio. Excluding inevitable components that become mixed with the material or become included during manufacturing, it is preferred that the metal elements of these materials be the elements that essentially form the auxiliary electrodes 2.

Among the above materials, it is preferred that the auxiliary electrodes 2 be formed of only Al or an alloy including Al as the main component and one or more of the above transition elements. It is preferable that the content of Al in the alloy be 90at% or more, and more preferably, 95at% or more.

The line width A of the auxiliary electrodes 2 on the transparent electrode 1 is not restricted.

It is preferred that the thickness B of the auxiliary electrodes 2 be less than the thickness of the organic layer 3. The thickness B of the auxiliary electrodes 2 is preferably 10 to 1000 nm, more preferably 20 to 500 nm, and most preferably 100 to 300 nm. When the light emitted from the organic layer 3 exits the transparent electrode 1, the auxiliary electrodes 2 may be transparent. In this case, it is preferred that the transmittance of the light emitted from the organic layer 3 be 80% or more. For example, when the auxiliary electrodes 2 are formed from Pt, the transmittance of visible light is approximately 82% when the thickness B is 1 nm. Thus, the thickness B is preferably 0.5 to 20 nm, and more preferably 1 to 10 nm.

Plasma treatment is performed on the surfaces of each auxiliary electrode 2 that do not contact the transparent electrode 1. The surfaces of the auxiliary electrode 2 need only be substantially plasma-treated and do not have to be completely plasma-treated. For example, plasma treatment of only the surface of the auxiliary electrode 2 facing away from the transparent electrode 1 or the surface contacting the organic layer 3 would be sufficient. Plasma treatment is performed on 50% or more of the portions of the auxiliary electrode 2 that are free from the transparent electrode 1, more preferably, 75% or more of the portions of the auxiliary electrode 2 that are free from the transparent electrode 1, and most preferably, 90% or more of the portions of the auxiliary electrode 2 that are free from the transparent electrode 1.

Known plasma treatments used to treat surfaces of electrodes, such as DC plasma treatment or RF plasma treatment, are employed as the plasma treatment.

Gas is used during the plasma treatment. Any gas may be employed as the treatment gas. For example, inert gas such as argon (Ar) may be used. Alternatively, gases such as oxygen (O) or nitrogen (N) may be used.

When using gas including oxygen for plasma treatment, the surface of the auxiliary electrode 2 free from the transparent electrode 1 is partially or completely oxidized. This hinders or completely stops the flow of current from the auxiliary electrode 2 to the organic layer 3. Especially, when the auxiliary electrode 2 is not transparent, most of the light emitted from the organic layer 3 at the rear side of the auxiliary electrode 2 would be blocked by the auxiliary electrode 2 and cannot be emitted out of the device. If there were to be no emission of light at such region of the organic layer 3 located at the rear side of the auxiliary electrode 2, this would reduce power consumption without affecting the amount of light exiting the device (i.e., the amount of usable light). Thus, the surfaces of the auxiliary electrode 2 that are free from the transparent electrode 1 may be insulative or have a resistance that is greater than that in the interior of the auxiliary electrode 2.

The flow rate of the treatment gas differs depending on the operation conditions or the type of the used gas. However, the flow rate is normally 5 to 500 SCCM in O₂ conversion. It is preferred that the operation pressure normally be approximately 0.3 to 5 Pa.

Normally, high frequency power having a high frequency of approximately 13.56 MHz and a power of approximately 0.1 to 5 kW is applied to a high frequency induction coil used for plasma treatment. However, this is only one example and the applied frequency and power may be of any value as long as it enables plasma to be generated and maintained.

The time of plasma treatment is preferably one minute or longer and more preferably two to twenty minutes.

The plasma treatment of the surfaces of the auxiliary electrode 2 in this manner substantially eliminates the occurrence of bright spots around the auxiliary electrode 2. Further, the luminance difference in the light exiting surface 50 between positions around each auxiliary electrode 2 and other positions is minimized.

Accordingly, the organic EL device of the preferred embodiment does not have luminance differences. It is believed that this is because the plasma treatment on the surfaces of each auxiliary electrode 2 smoothes the surfaces and eliminates portions where the auxiliary electrode 2 contacts the opposing electrode 4 or is located closely to the opposing electrode 4.

In the prior art, bright spots are produced, and portions brighter than other portions are produced. It is believed that this occurs due to land and pits formed in each auxiliary electrode 2. The lands and pits result in portions at which the distance between the auxiliary electrode 2 and the opposing electrode 4 becomes extremely short. This causes the thickness of the organic layer 3 arranged between the auxiliary electrode 2 and the opposing electrode 4 at such portions to be thinner than other portions. The resistance at thin portions of the organic layer 3 is lower than other portions. Thus, more current flows at the thin portions and increases the luminance of the thin portions. Further, the temperature is higher at portions where more current flows. This further decreases the resistance and increases the luminance. Accordingly, this would produce bright spots near the auxiliary electrode 2 in the light exiting surface 50, and the luminance at such portions would be higher than other portions.

However, in the organic EL device of the preferred embodiment, the auxiliary electrode 2 is smoothed. Thus, a sufficient distance is provided between the auxiliary electrode 2 and the opposing electrode 4. In other words, the thickness of the organic layer 3 between the auxiliary electrode 2 and the opposing electrode 4 is sufficient in comparison to other positions. This prevents the luminance from increasing and bright spots from being produced. As a result, luminance differences are substantially eliminated. Further, this prolongs the life of the elements at such portions. This, in turn, prolongs the life of the organic EL device.

It has been confirmed that there are substantially no bright spots or luminance differences when the surface roughness of the auxiliary electrode 2 is as described below.
(1) The surface of the auxiliary electrode 2 is smoothed to 80 nm or less under the ten point height of roughness profile standard, which is defined by the Japanese Industrial Standard (JIS) B0601 2001. The ten point height of roughness profile is obtained from a roughness profile of a predetermined sampling length. The mean of the heights of the highest peak to the fifth highest peak in the roughness profile is added to the mean of the depths of the lowest valley to the fifth lowest valley in the roughness profile. The sum of the means is referred to as the ten point height of roughness.
(2) The auxiliary electrode 2 is smoothed so that its surface roughness under the ten point height of roughness profile standard is less than or equal to the thickness of the organic layer 3.

In the above conditions, there is no lower limit to the ten point height of roughness profile standard. However, satisfactory results were obtained when the surface roughness of the auxiliary electrode 2 was approximately 20 nm.

The smoothing of the auxiliary electrode 2 in this manner eliminates leakage from between the auxiliary electrode 2 and the opposing electrode 4 and eliminates extremely thin portions from the organic layer 3.

When designing the surface of the auxiliary electrode 2 so that the ten point height of roughness profile standard satisfies the above condition after the arithmetical mean deviation of the surface becomes 0.1 nm or greater and 5.0 nm or less, the results are especially satisfactory. The arithmetical mean deviation is defined by JIS B0602 2001.

When the surface roughness under the ten point height of roughness profile standard of the auxiliary electrode 2 is 1/1.6 or less of the thickness of the organic layer 3, the resulting organic EL device has minimized luminance differences and the possibility of bright spots being produced is extremely small.

The auxiliary electrodes 2 are formed on the transparent electrode 1 using known film formation processes, such as plasma chemical vapor deposition (CVD), sputtering, vacuum vapor deposition, and EB vapor deposition. It is especially preferred that vacuum vapor deposition be performed to form the auxiliary electrodes 2 from the same material as that of the cathode so that the electrodes may be formed in the same vacuum vapor deposition device.

The employment of sputtering increases adhesion between the transparent electrode 1 and the auxiliary electrodes 2.

When performing sputtering, the target that is used has the same composition as the auxiliary electrodes 2 (sinter formed from the above metals or alloy). The auxiliary electrodes 2 that are formed have substantially the same composition as the target.

It is preferred that the pressure of sputtering gas during sputtering be in the range of 0.5 to 5 Pa. A hole injection layer having a concentration gradient may easily be obtained by varying the pressure of the sputtering gas in the above range when performing sputtering.

An inert gas that is used in a typical sputtering device may be used. Among such gases, it is preferred that one of Ar, Kr, and Xe or a gas mixture including at least one of these substances be used.

Further, reactive sputtering using a reactive gas may also be performed. When forming an oxide, gases such as O₂ and CO may be used as the reactive gas. When forming a nitride, gases N₂, NH₃, NO, NO₂, and N₂O may be used as the reactive gas. When forming a carbide, gases such as CH₄, C₂H₂, C₂H₄, and CO may be used as the reactive gas. These reactive gases may be used solely or in combination with other gases.

The sputtering may be DC sputtering or high frequency sputtering, which uses an RF power supply. However, RF sputtering is more preferable. The preferred film-forming rate is 0.5 to 10 nm/min.

A know pattering process may be used to form the auxiliary electrodes 2 with a predetermined shape on the transparent electrode 1. For example, a patterning process using a resist that is normally used may be performed. In this case, dry etching or wet etching may be performed. When performing wet etching, it is preferred that the etching liquid used for wet etching be one selected in accordance with each metal. For example, when forming the auxiliary electrode 2 from Al, a mixture solution of phosphoric acid, nitric acid, and acetic acid may be used.

A barrier layer formed from titanium nitride or the like may be arranged between the auxiliary electrode 2 and the transparent electrode 1. It is preferred that the barrier layer has a sufficient etching characteristic with respect to the etchant of the auxiliary electrode 2. The preferred material of the barrier layer is chromium; a nitride, such as titanium nitride, molybdenum nitride, tantalum nitride, and chromium nitride; a silicide, such as cobalt silicide, chromium silicide, molybdenum silicide, tungsten nitride, and titanium silicide; titanium carbide; and doped silicon carbide. Among these substances, titanium nitride and chromium are preferable since they have superior anti-corrosion characteristics. The nitriding rate of titanium nitride is 5 to 55%.

The thickness of the barrier layer is preferably 5 to 200 nm, and more preferably, 30 to 100 nm.

### <Transparent Electrode 1>

The transparent electrode 1 is an electrode arranged on the light-exiting side of the organic layer 3. In the preferred embodiment, the transparent electrode 1 functions as an anode arranged on the transparent substrate 5.

It is preferred that the material forming the transparent electrode 1 be one that enables efficient injection of positive holes in the organic layer 3 (which includes a positive hole injection layer and a positive hole injection transportation layer). The preferred material is normally a substance having a work function of 4.5 to 5.5 eV. More specifically, the preferred material is one of which main composition is indium-tin-oxide (ITO), indium-zinc-oxide (IZO), indium oxide (In₂O₃), tin oxide (SnO₂), and zinc oxide (ZnO).

These oxides may be slightly biased from the stoichiometric composition. The mixing ratio of SnO₂ relative to In₂O₃ in ITO is 1 to 20 wt% and more preferably 5 to 12 wt%. The mixing ratio of ZnO relative to In₂O₃ in IZO is approximately 12 to 32 wt%. If the average value of the composition in the entire transparent electrode 1 falls in this range, there may be a concentration gradation in the direction perpendicular to the plane of the transparent electrode 1.

Additionally, substances, such as Sn, Ti, and Pb, may be included in the form of oxides at 1 wt% or less in oxide conversion.

In this specification, the term "transparent" refers to the light transmittance, in which light exiting from the device, is 50% or greater, preferably 80% or greater, and more preferably 90% or greater. Normally, light having a wavelength of 400 to 800 nm (visible light) is emitted out of the device. When the transmittance becomes too low, the light emission from the luminescent layer is attenuated. This makes it difficult to obtain the necessary luminance from the luminescent device.

The thickness of the transparent electrode 1 is required only to enable sufficient injections of positive holes in the organic layer 3. The preferred thickness of the transparent electrode 1 is normally 10 to 50 nm. Although there is no limit to the upper limit of the thickness, when the transparent electrode 1 is too thick, the transmittance may decrease or exfoliation of the transparent electrode 1 may occur. If the transparent electrode 1 is too thin, the injection of positive holes may be disabled and the film strength may be insufficient when manufacturing the device. It is necessary that the drive voltage be low to increase the reliability of the device. The preferred electrode is a sheet of ITO having a resistance of 3 to 30 Ω and a thickness of 50 to 300 nm. For actual usage, the thickness or optical constant of the electrode may be set so that the buffering effect resulting from reflection at the hole injection electrode interface of ITO or the like sufficiently satisfies the required light exiting efficiency or the color purity.

The transparent electrode 1 may be formed through a known film formation process such as vapor deposition. However, it is preferred that the transparent electrode 1 be performed through sputtering. When performing sputtering to form an ITO or IZO electrode, it is preferred that a target in which SnO₂ or ZnO is doped in In₂O₃ be used. When forming an ITO transparent electrode through sputtering, moment-to moment change in the luminance of the emitted light is small in comparison to when forming an electrode through vapor deposition. The preferred sputtering is DC sputtering or RF sputtering, the power that is used is preferably in the range of 0.1 to 4 W/cm². The film forming rate is 2 to 100 nm/min, and more preferably 5 to 50 nm/min. The sputtering gas is not limited and an inert gas, such as Ar, He, Ne, Kr, and Xe, or a mixture of these gases may be used. The pressure of the sputtering gas during sputtering is normally about 0.1 to 20 Pa.

Further, in the same manner as the auxiliary electrodes 2, plasma treatment may be performed on the transparent electrode 1. When performing the plasma treatment, the transparent electrode 1 and the auxiliary electrodes 2 may be treated together (simultaneously) or separately.

The organic layer 3 and the opposing electrode 4 will now be described.

### <Organic Layer 3>

The organic layer 3 includes an organic luminescent material such as Alq3 or DCM. The organic layer 3, of which the main composition is an organic material, emits electroluminescence when voltage is applied between the transparent electrode 1 and the opposing electrode 4.

The organic layer 3 includes one layer or a plurality of superimposed layers. When the organic layer 3 has a superimposed structure, layers including the organic luminescent material are referred to as luminescent layers.

### [Layer Structure]

Referring to Fig. 1, the transparent electrode 1, which functions as an anode, is formed on the substrate 5. The auxiliary electrodes 2 are formed on the transparent electrode 1. A hole injection transport layer 30, a luminescent layer 31, and an electron injection transport layer 32 are formed on the transparent electrode 1 and the auxiliary electrode 2 on the side facing away from the transparent substrate 5. The hole injection transport layer 30, the luminescent layer 31, and the electron injection transport layer 32 form the organic layer 3. However, the organic layer 3 is not limited to such structure and may have other structures.

For example, the hole injection transport layer 30 may be eliminated by providing the luminescent layer with the functions of the hole injection transport layer, that is, a hole injection function and a hole import function. Alternatively, the electron injection transport layer 32 may be separated into an electron injection layer provided with an electron injection function and an electron transport layer provided with the electron injection function. In this case, the electron injection layer and the electron transport layer are superimposed with each other. Examples of other alternatives of the structure of the organic layer 3 are listed below.
(Anode) / hole injection layer / hole transport layer / luminescent layer / non-luminescent layer / electron transport layer / electron injection layer / (cathode)
(Anode) / hole injection layer / hole transport layer / luminescent layer / non-luminescent layer / electron injection transport layer / (cathode)
(Anode) / hole injection transport layer / luminescent layer / non-luminescent layer / electron transport layer / electron injection layer / (cathode.)
(Anode) / hole injection transport layer / luminescent layer / non-luminescent layer / electron injection transport layer / (cathode)
(Anode) / luminescent layer / non-luminescent layer / electron transport layer / electron injection layer / (cathode)
(Anode) / luminescent layer / non-luminescent layer / electron injection transport layer / (cathode)

Each of the above layers may be provided with various functions. For example, the luminescent layer may be provided with a hole transport function, a hole injection function, an electron injection function, and/or an electron transport function.

Layers that are not described above may also be included. The layers may also be superimposed in a substrate starting from the cathode to form the organic EL device.

### [Hole Injection Transport Layer 30]

The hole injection transport layer 30, into which holes are injected from the transparent electrode 1 and which transports the injected holes to the luminescent layer 31, is arranged between the transparent electrode 1 and the luminescent layer 31. Ionization energy of the hole injection transport layer 30, which is set to be between the work function of the transparent electrode 1 and the ionization energy of the luminescent layer 31, is usually set at 5.0 to 5.5 eV.

The organic EL device of Fig. 1 that includes the hole injection transport layer 30 has the following properties.
(1) Driving voltage is low.
(2) Injection of holes into the luminescent layer 31 from the transparent electrode is stabilized. This prolongs the life of the device.
(3) Adhesion between the opposing electrode 4, which functions as the cathode, and the luminescent layer 31 increases. This increases the uniformity of the luminescent surface.
(4) The coating of the protrusions on the surface of the anode reduces device deficiencies.

When the light emitted by the luminescent layer 31 is output through the hole injection transport layer 30, the hole injection transport layer 30 is transparent. Among the materials that can form the hole injection transport layer 30, the material is selected from one that transmits the emitted light when formed into a thin film. In general, the transmittance of the hole injection transport layer 30 with respect to the emitted light is greater than 10%.

The material for forming the hole injection transport layer 30 is not especially limited as long as the above-described properties are imparted to the hole injection transport layer 30. Any known material used as a hole injection material of a photoconductive device or any known material used for a hole injection transport layer in an organic EL device may be used.

Examples of the material for forming the hole injection transport layer 30 include phthalocyanine derivatives, triazole derivatives, triarylmethane derivatives, triarylamine derivatives, oxazole derivatives, oxadiazole derivatives, hydrazone derivatives, stilbene derivatives, pyrazoline derivatives, pyrazolone derivatives, polysilane derivatives, imidazole derivatives, phenylenediamine derivatives, amino substituted chalcone derivatives, styrylanthracene derivatives, fluorenone derivatives, hydrazone derivatives, silazane derivatives, aniline copolymer, porphyrin compounds, polyarylalkane derivatives, polyphenylene vinylene and derivatives thereof, polythiophene and derivatives thereof, poly-N-vinylcarbazole derivatives, electroconductive polymeric oligomers such as thiophene oligomer, metallophthalocyanines such as copper phthalocyanine, and tetra(t-butyl)copper phthalocyanine, metal-free phthalocyanines, quinacridone compounds, aromatic tertiary amine compounds, and styrylamine compounds.

Examples of the triarylamine derivatives include 4,4'-bis[N-phenyl-N-(4"-methylphenyl)amino]biphenyl, 4,4'-bis [N-phenyl-N-(3"-methylphenyl)amino] biphenyl, 4,4'-bis[N-phenyl-N-(3"-methoxyphenyl)amino]biphenyl, 4,4'-bis[N-phenyl-N-(1"-naphththyl)amino]biphenyl, 3,3'-dimethyl-4,4'-bis[N-phenyl-N-(3"-methylphenyl)amino]biphenyl, 1,1-bis[4'-[N,N-di(4"-methylphenyl)amino]phenyl]cyclohexane, 9,10-bis[N-(4'-methylphenyl)-N-(4"-n-butylphenyl)amino]phenanthrene, 3,8-bis(N,N-diphenylamino)-6-phenanthridine, 4-methyl-N,N-bis[4",4"'-bis[N',N"-di(4-methylphenyl)amino]biphenyl-4-yl]aniline, N,N''-bis[4-(diphenylamino)phenyl]-N,N'-diphenyl-1,3-diaminobenzene, N,N'-bis[4-(diphenylamino)phenyl]-N,N'-diphenyl-1,4-diaminobenzene, 5,5"-bis [4-(bis[4-methylphenyl] amino)phenyl]-2,2':5',2"-terthiophen, 1,3,5-tris(diphenylamino)benzene, 4,4',4"-tris(N-carbazolyl)triphenylamine, 4,4',4"-tris[N-(3'''-methylphenyl)-N-phenylamino]triphenylamine, 4,4',4"-tris[N,N-bis(4'''-tert-butylbiphenyl-4""-yl)amino]triphenylamine, and 1,3,5-tris[N-(4'-diphenylaminophenyl)-N-phenylamino]benzene.

Examples of the porphyrin compounds include porphin, 1,10,15,20-tetraphenyl-21H,23H-porphin copper (II), 1,10,15,20-tetraphenyl-21H,23H-porphin zinc (II), 5,10,15,20-tetrakis (pentafluorophenyl)-21H,23H-porphin, silicon phthalocyanine oxide, aluminum phthalocyanine chloride, phthalocyanine (metal-free), dilithium phthalocyanine, copper tetramethyl phthalocyanine, copper phthalocyanine, chromium phthalocyanine, zinc phthalocyanine, lead phthalocyanine, titanium phthalocyanine oxide, magnesium phthalocyanine, and copper octamethyl phthalocyanine.

Examples of the aromatic tertiary amine compounds and the styrylamine compounds include N,N,N',N'-tetraphenyl-4,4'-diaminophenyl, N,N'-diphenyl-N,N'-bis-(3-methylphenyl)-[1,1'-biphenyl]-4,4'-diamine, 2,2-bis(4-di-p-tolylaminophenyl) propane, 1,1-bis(4-di-p-tolylaminophenyl)cyclohexane, N,N,N',N'-tetra-p-tolyl-4,4'-diaminophenyl, 1,1-bis(4-di-p-tolylaminophenyl)-4-phenylcyclohexane, bis(4-dimethylamino-2-methylphenyl)phenylmethane, bis(4-di-p-tolylaminophenyl)phenylmethane, N,N'-diphenyl-N,N'-di(4-methoxyphenyl)-4,4'-diaminobiphenyl, N,N,N',N'-tetraphenyl-4,4'-diaminophenyl ether, 4,4'-bis(diphenylamino)quadriphenyl, N,N,N-tri(p-tolyl)amine, 4-(di-p-tolylamino)-4'-[4(di-p-tolylamino)styryl]stilbene, 4-N,N-diphenylamino-(2-diphenylvinyl)benzene, 3-methoxy-4'-N,N-diphenylamino stilbenzene, and N-phenylcarbazole. Further, aromatic dimethylidene compounds may be used as the materials of the hole injection transport layer 30.

The hole injection transport layer 30 may be formed from one of the above materials or from a mixture of a plurality of the above materials. Further, the hole injection transport layer 30 may have a multi-layered structure including multiple layers having the same composition or different compositions.

The hole injection transport layer 30 may be formed on the anode using a known thin film formation process, such as a vacuum vapor deposition, spin coating, casting, or LB process. The layer thickness is normally 5 nm to 5 µm, although it depends on the selected material.

### [Luminescent Layer 31]

The luminescent layer 31 is mainly formed from an organic material. The luminescent layer 31 has holes and electrons injected from the transparent electrode 1 and the opposing electrode 4, transports at least either the holes or the electrons, recombines the holes and the electrons to generate excitons, and emits electroluminescence (light) when the excitons return to a ground state.

Therefore, the material (organic material) of the luminescent layer 31 is only required to have the following functions:
hole injection function allowing injection of holes from the hole injection transport layer 30 (or transparent electrode 1);
electron injection function allowing injection of electrons from the electron injection transport layer 32;
transport function for transporting at least either the injected holes or electrons with the force of an electric field;
function for recombining the holes and the electrons to produce an excited state (excitons); and
function for generating electroluminescence when transition from the excited state to the ground state occurs.

Typical examples of having the above functions include Alq3 and Be benzoquinolinol (BeBq2). Further, the following materials may also be used.

Benzoxazole materials such as 2,5-bis(5,7-di-tert-pentyl-2-benzoxazolyl)-1,3,4-thiadiazole, 4,4'-bis(5,7-pentyl-2-benzoxazolyl)stilbene, 4,4'-bis[5,7-di-(2-methyl-2-butyl)-2-benzoxazolyl]stilbene, 2,5-bis(5,7-di-tert-pentyl-2-benzoxazolyl)thiophine, 2,5-bis([5-α,α-dimethylbenzyl]-2-benzoxazolyl)thiophene, 2,5-bis[5,7-di-(2-methyl-2-butyl)-2-benzoxazolyl]-3,4-diphenylthiophene, 2,5-bis(5-methyl-2-benzoxazolyl)thiophene, and 4,4'-bis(2-benzoxazolyl)biphenyl, 5-methyl-2-[2-[4-(5-methyl-2-benzoxazolyl)phenyl]vinyl]benzoxazolyl, 2-[2-(4-chlorophenyl)vinyl]naphth[1,2-d]oxazole; benzothiazole materials such as 2,2'-(p-phenylene divinylene)-bis benzothiazole; benzimidazole fluorescent whitening agents such as 2-[2-[4-(2-benzimidazolyl)phenyl]vinyl]benzimidazole, and 2-[2-(4-carboxyphenyl)vinyl]benzimidazole; 8-hydroxyquinoline metallic complexes such as bis(8-quinolinol)magnesium, bis(benzo-8-quinolinol)zinc, bis(2-methyl-8-quinolinolate) aluminium oxide, tris(8-quinolinol)indium, t ris(5-methyl-8-quinolinol)aluminium, 8-quinolinol lithium, tris (5-chloro-8-quinolinol) gallium, bis(5-chloro-8-quinolinol) calcium, and poly[zinc-bis(8-hydroxy-5-quinolinonyl)methane]; metal chelated oxynoid compounds such as dilithium epindrydione; styryl benzene compounds such as 1,4-bis(2-methylstyryl)benzene, 1,4-(3-methylstyryl)benzene, 1,4-bis(4-methylstyryl)benzene, distyrylbenzene, 1,4-bis(2-ethylstyryl) benzene, 1,4-bis(3-ethylstyryl) benzene, and 1,4-bis(2-methylstyryl)2-methylbenzene; distyryl pyrazine derivatives such as 2,5-bis (4-methylstyryl)pyrazine, 2,5-bis(4-ethylstyryl)pyrazine, 2,5-bis[2-(1-naphthyl)vinyl]pyrazine, 2,5-bis(4-methoxystyryl)pyrazine, 2,5-bis[2-(4-biphenyl)vinyl]pyrazine, and 2,5-bis[2-(1-pyrenyl)vinyl]pyrazine; naphthalimide derivatives; perylene derivatives; oxadiazole derivatives; aldazine derivatives; cyclopentanediene derivatives; styrylamine derivatives; cumarin derivatives; aromatic dimethylidine derivatives; anthracene; salicylate; pyrene; coronene and, phosphorescent materials, such as fac-tris(2-phenylpyridine)iridium.

Further, the luminescent layer 31 may contain a material (organic luminescent material/dopant) having a function for generating electroluminescence and a material (host material) having other functions. In this case, the host material injects and transports carriers and is raised to an excited state by recombination. The excited host material transfers excitation energy to the dopant. The dopant generates electroluminescence when returning to the ground state. In general, a fluorescent material or a phosphorescent material is used as the dopant.

The host material is only required to have the above functions and known materials may be used as the host material. Examples of the host material include distyrylallylene derivatives, distyrylbenzene derivatives, distyrylamine derivatives, quinolinolate metallic complexes, triarylamine derivatives, azomethine derivatives, oxadiazole derivatives, pyrazoloquinoline derivatives, silole derivatives, naphthalene derivatives, anthracene derivatives, dicarbazole derivatives, perylene derivatives, oligothiophene derivatives, cumarin derivatives, pyrene derivatives, tetraphenylbutadiene derivatives, benzopyrane derivatives, europium complexes, rubrene derivatives, quinacridone derivatives, triazole derivatives, benzoxazole derivatives, and benzothiazole derivatives.

The fluorescent material is a material, such as a fluorochrome or a fluorescent dopant, capable of emitting light during transition to the ground state after receiving excitation energy from the host material. This enables the exit of light from the singlet state of excitation under normal temperatures. In general, a material having a high quantum efficiency of fluorescence is selected as the fluorescent material. The amount of fluorescent material to be doped to the host material is 0.01 wt% or more to 20 wt% or less with respect to the host material.

The fluorescent material is only required to be selected from known materials having the above properties. Examples of the fluorescent material include europium complexes, benzopyrane derivatives, rhodamine derivatives, benzothioxanthen derivatives, porphyrin derivatives, Nile red, 2-(1,1-dimethylethyl)-6-(2-(2,3,6,7-tetrahydro-1,1,7,7-tetramethyl-1H, 5H-benzo(ij)quinolidin-9-yl)ethenyl)-4H-pyrane-4H-ylidene)propanedinitrile (DCJTB), DCM, cumarin derivatives, quinacridone derivatives, distyrylamine derivatives, pyrene derivatives, perylene derivatives, anthracene derivatives, benzoxazole derivatives, benzothiazole derivatives, benzimidazole derivatives, chrysene derivatives, phenanthrene derivatives, distyrylbenzene derivatives, tetraphenylbutadiene, and rubrene.

The phosphorescent material is a material, such as a phosphorescent dye or a phosphorescent dopant, capable of emitting light during transition to the ground state after receiving excitation energy from the host material. This enables the exit of light from the singlet and triplet states under normal temperatures. In general, the amount of phosphorescent material to be doped to the host material is 0.01 wt% or more to 30 wt% or less with respect to the host material.

The phosphorescent material is not limited as long as it enables usage of light emission from the singlet and triplet states of excitation under normal room temperatures. A known phosphorescent material may be used as the phosphorescent material. In general, heavy metal complexes capable of emitting phosphorescent light are used as the phosphorescent material.

For example, tris(2-phenylpyridine)iridium may be used as a green phosphorescent material. Further, 2,3,7,8,12,13,17,18-octaethyl-21H23H-porphinplatinum(II) may be used as a red phosphorescent material. Other metals or nonmetals may be substituted for the central metals of the above materials.

The luminescent layer 31 may be formed on the hole injection transport layer 30 with a known thin film formation process, such as the vacuum vapor deposition, spin coating, casting, or LB process. The layer thickness of the luminescent layer 31 is generally about 1 nm to 100 nm, and preferably about 20 nm to 50 nm, although it depends on the used material.

Further, if the same layer is doped with a plurality of dopants, it becomes possible to mix colors of emitted light, emit two or more light colors, and efficiently transfer the energy to a second dopant having a lower energy level after transferring energy from the host material to a first dopant having a low energy level.

The chromaticity, saturation, brightness, and luminance of light (electroluminescence) emitted from the luminescent layer 12 are adjusted by selecting the kind of material of the luminescent layer 31, adjusting the amount of the dopant that is doped, and adjusting the thickness of the luminescent layer 31. It is also possible to adjust the luminescent color of light emitted from the luminescent layer 31 through the processes described below. The luminescent color may be adjusted by using one of these processes or by using more than one of these processes.
* Process for adjusting the luminescent color by arranging a color filter on the light exiting side of the luminescent layer 31

The color filter adjusts the luminescent color by limiting the wavelength range of light transmitted through the filter. Color filters are made by using known materials. For example, a blue filter is made of cobalt oxide, a green filter is made of a mixture of cobalt oxide and chromium oxide, and a red filter is made of ferrous oxide. The color filter may be formed on the substrate 5 by using a known thin film formation process, such as vacuum vapor deposition.
* Process for adjusting the luminescent color by doping materials for enhancing or inhibiting luminescence

For example, the luminescent layer 31 is doped with a so-called assist dopant, which receives energy from the host material and transfers the energy to the dopant. This facilitates energy transfer from the host material to the dopant. The assist dopant is selected from known materials, such as the materials used as the above host materials and dopants.
* Process of adjusting the luminescent color by doping a layer (including the substrate 5) at the light exiting side of the luminescent layer 31 with a material for changing the wavelengths of the emitted light

A known wavelength converting material may be used as this material. For example, the material that is used may be a fluorescence conversion substance that converts light emitted from the luminescent layer 31 to another light having low energy wavelengths. The fluorescence conversion substance is selected as required in accordance with the wavelengths of light emitted from the organic EL device and the wavelengths of light emitted from the luminescent layer 31. Further, although the amount of the fluorescence conversion substance used may be selected as required depending on the kind of fluorescence conversion substance as long as it does not cause concentration quenching. Approximately 10⁻⁵ to 10⁻⁴ mol/liter is suitable with respect to a transparent (uncured) resin. It is possible to use only one type of a fluorescence conversion substance or plural types of fluorescence conversion substances. When plural types of fluorescence conversion substances are used, in addition to blue light, green light, and red light, white light and light having an intermediate color may be emitted depending on the combination of the substances. As the above fluorescence conversion substances, materials described in the following paragraphs (a) to (c) may be used.
(a) Fluorescence conversion substances which emit blue light when excited by ultraviolet rays
   stilbene dyes, such as 1,4-bis(2-methylstyrene)benzene and trans-4,4'-diphenylstilbene; coumarin-based dyes, such as 7-hydroxy-4-methylcoumarin; and aromatic dimethylidene-based dyes, such as 4,4'-bis(2,2-diphenylvinyl)biphenyl.
(b) Fluorescence conversion substances which emit green light when excited by blue light
   coumarin dyes, such as 2,3,5,6-1H,4H-tetrahydro-8-trifluoromethylquinolizino(9,9a,1-gh)coumarin (coumarin 153).
(c) Fluorescence conversion substances which emit light having wavelengths of orange to red when excited by light having wavelengths of blue to green
   cyanine dyes, such as 4-(dicyanomethylene)-2-methyl-6-(p-dimethylaminostyrylryl)-4H-pyrane, 4-(dicyanomethylene)-2-phenyl-6-(2-(9-julolidyl)ethenyl)-4H-pyrane, 4-(dicyanomethylene)-2,6-di(2-(9-julolidyl)ethenyl)-4H-pyrane, 4-(dicyanomethylene)-2-methyl-6-(2-(9-julolidyl)ethenyl)-4H-pyrane, and 4-(dicyanomethylene)-2-methyl-6-(2-(9-julolidyl)ethenyl)-4H-thiopyrane; pyridine dyes such as 1-ethyl-2-(4-(p-dimethylaminophenyl)-1,3-butadienyl)-pyridium-percolate (pyridine 1); xanthine dyes, such as rhodamine B and rhodamine 6G; and oxazine dyes.

### [Electron Injection Transport Layer 32]

The electron injection transport layer 32 is arranged between the opposed electrode 4 and the luminescent layer 31 to transport the electrons injected from the opposed electrode 4 to the luminescent layer 31 and provides the organic EL device with the properties described below:
(1) Decrease driving voltage.
(2) Stabilize injection of holes into the luminescent layer 31 from the opposing electrode 4. This prolongs the life of the device.
(3) Increase adhesion between the opposing electrode 4, which functions as the cathode, and the luminescent layer 31. This increases the uniformity of the luminescent surface.
(4) Coating the protrusions on the surface of the anode to reduce device deficiencies.

The material for the electron injection transport layer 32 is selected from known materials used as electron injection materials for photoconductive materials and known materials used for forming electron injection transport layers in organic EL devices. In general, material having electron affinity between the work function of the cathode and the electron affinity of the luminescent layer 31 is used.

Specific examples of such materials include 1,3-bis[5'-(p-tert-butylphenyl)-1,3,4-oxadiazol-2'-yl]benzene and 2-(4-biphinylyl)-5-(4-tert-butylphenyl)-1,3,4-oxadiazole; and triazole derivatives such as 3-(4'-tert-butylphenyl)-4-phenyl-5-(4"-biphenyl)-1,2,4-triazole. Further, triazine derivatives, perylene derivatives, quinoline derivatives, quinoxaline derivatives, diphenylquinone derivatives, nitration fluorenone derivatives, thiopyranedioxide derivatives, anthraquinodimethane derivatives, thiopyranedioxide derivatives, heterocycle tetracarboxylic acid anhydrides such as naphthaleneperylene, carbodiimide, fluorenylidenemethane derivatives, anthraquinodimethane derivatives, anthron derivatives, and distyryl pyrazine derivatives may be used.

Organometal complexes, such as bis(10-benzo[h]quinolinolato)beryllium, a beryllium salt of 5-hydroxyflavone and an aluminum salt of 5-hydroxyflavone are preferably used. Metal complexes of 8-hydroxyquinoline or its derivatives are further preferably used. More specifically, it is possible to use metal chelate oxynoid compounds having oxine (also known as 8-quinolinol or 8-hydroxyquinoline) ligands, such as tris(8-quinolinolato) aluminum, tris (5, 7-dichloro-8-quinolinolato) aluminum, tris(5,7-dibromo-8-quinolinolato) aluminum, and tris(2-methyl-8-quinolinolato) aluminum may be used. It is also possible to use metal complexes formed by substituting indium, magnesium, copper, calcium, tin or lead for the central metals of the above metal complexes. Metal-free phthalocyanine, metal phthalocyanine, or compounds having terminals of these compounds substituted by an alkyl group or a sulfone group may also be used.

The electron injection transport layer 32 may be formed by only one of the above materials or by mixing a plurality of the above materials. Further, the electron injection transport layer 32 may have a multi-layered structure including multiple layers having the same composition or different compositions.

The electron injection transport layer 32 is formed by using one or more of the above materials by performing any one of the known thin film formation processes, such as the sputtering, ion plating, vacuum vapor deposition, spin coating, and electron beam vapor deposition processes. The thickness of the electron injection transport layer 32 is normally 5 nm to 5 µm.

When the electron injection transport layer 32 is arranged at the light exit side of the luminescent layer 31, the electron injection transport layer 32 is required to be transparent with respect to the exiting light. Thus, a material that is transparent when formed into a thin film is selected from the above-mentioned materials capable of forming the electron injection transport layer 32. In general, the transmittance of the electron injection transport layer 32 with respect to exiting light is set to be greater than 10%.

### (Other layers and dopants)

The organic EL device of the preferred embodiment may be provided with a known layer other than the layers shown in Fig. 1. Further, the formed layers may be doped with a known dopant. For example, the variations described below are possible.

### [Layers Between Layers]

Interlayer layers for enhancing electron injection and hole injection may be provided. For example, a cathode interface layer (mixed electrode), which is formed by co-depositing the materials of the opposing electrode 4 and the electron injection transport layer 32 may be interposed between the opposing electrode 4 and the electron injection transport layer 32. This makes it possible to alleviate an energy barrier blocking electron injection between the luminescent layer 31 and the opposing electrode 4. It also enhances adhesion between the opposing electrode 4 and the electron injection transport layer 32.

The cathode interface layer may be formed by using any known material that imparts the above properties to the cathode interface layer. For example, it is possible to use alkali metals, such as lithium fluoride, lithium oxide, magnesium fluoride, calcium fluoride, strontium fluoride, and barium fluoride, and fluorides, oxides, chlorides, and sulfides of alkaline-earth metals. The cathode interface layer may be formed from only one of the above materials or from more than one of the above materials. The thickness of the cathode interface layer is about 0.1 nm to 10 nm, preferably 0.3 nm to 3 nm.

The cathode interface layer may have a uniform thickness or a non-uniform thickness. Further, the cathode interface layer may have an island-like shape and may be formed employing a known thin film formation process, such as the vacuum vapor deposition process.

### [Protective Layer]

In order to prevent the organic EL device 100 from being brought into contact with oxygen and water, a protective layer (sealing layer, passivation film) may be provided. An organic polymer material, an inorganic material, and a photo-curing resin may be used as the material of the protective layer. When forming the protective layer, one or a plurality of these materials may be used. The protective layer may have a single-layered structure or a multi-layered structure.

Examples of the organic polymer material include chlorotrifluoroethylene polymer, dichlorodifluoroethylene polymer, fluorine resins such as a copolymer of chlorotrifluoroethylene polymer and dichlorodifluoroethylene polymer, acryl resin such as polymethyl methacrylate, and polyacrylate, epoxy resin, silicone resin, epoxy-silicone resin, polystyrene resin, polyester resin, polycarbonate resin, polyamide resin, polyimide resin, polyamide-imide resin, poly paraxylene resin, polyethylene resin, and polyphenylene oxide resin.

As the inorganic material, a thin film of diamond, amorphous silica, electrical insulating glass, metal oxides, metal nitrides, metal carbides, and metal sulfides may be used.

The above materials may be doped with the aforementioned fluorescence conversion substance. Further, the organic EL device may be protected by sealing the organic EL device in inert substances, such as paraffin, liquid paraffin, silicone oil, fluorocarbon oil, and zeolite-added fluorocarbon oil.

### [Doping of Hole Injection Transport Layer 30 and Electron Injection Transport Layer 32]

The hole injection transport layer 30 and the electron injection transport layer 32 may be doped with organic luminescent materials (dopants), such as a fluorescent material and a phosphorescent material, so that light is also emitted from the hole electron injection transport layer 30 and the electron injection transport layer 32.

### [Doping Layers Adjacent to the Opposing Electrode 4 With an Alkali metal and an Alkali Metal Compound]

When the cathode 15 is formed using a metal, such as aluminum, a layer adjacent to the opposing electrode 4 may be doped with an alkali metal or an alkali metal compound to alleviate an energy barrier existing between the opposing electrode 4 and the organic luminescent layer 31. The organic layer is chemically reduced by the metal or the compound to generate anions. This increases electron injection and lowers the applied voltage. As the alkali metal compound, for example, oxides, fluorides, and chelated lithium compounds may be used.

### <Opposing Electrode 4>

The opposing electrode 4, which cooperates with the transparent electrode 3 to hold the organic layer 3 in between, functions as a cathode for injecting electrons into the electron injection transport layer 32. The opposing electrode 4 is made of a metal, an alloy, an electroconductive compound, or a mixture of these substances that have a work function of, for example, less than 4.5 eV, normally 4.9 eV or less, and typically 3.7 eV or less to increase the electron injecting efficiency. For example, K, Li, Na, Mg, La, Ce, Ca, Sr, Ba, Al, Ag, in, Sn, Zn, Zr may be used. These elements may be used solely or, to increase stability, in a state included in a two component or three component alloy. Alloys such as Ag·Mg (Ag: 0.01 to 50 at%), Al·Li (Li: 0.01 to 12 at%), In·Mg (Mg: 50 to 80 at%), and Al·Ca (Ca: 0.01 to 20 at%) prevent the opposing electrode 4 from being oxidized and are preferable for increasing adhesion to the organic layer 3 (electron injection transport layer 32). Further, it is preferable that an oxide of these materials or a lithium oxide be used. This surrounds the organic layer 4 with the opposing electrode 4, which is an oxide, and the transparent electrode 2, which is an oxide such as ITO. This improves weather-resistance. Further, the materials used to form the anode may also be used.

When the opposing electrode 4 is used as a reflective electrode, among the above materials, materials provided with a function that reflects light emitted externally are selected. Normally, metals, alloys, and metals alloys are selected.

The opposing electrode 4 may have a multi-layer structure including a plurality of layers made of the same composition or different compositions. For example, to reduce the work function of the opposing electrode 4, oxides, fluorides, metal, and compounds having a small work function are inserted in the interface between the opposing electrode 4 and the electron injection transport layer 32 to reduce the work function of the opposing electrode 4. For example, the material of the opposing electrode 4 may be aluminum, and lithium fluoride or lithium oxide is inserted in the interface.

The opposing electrode 4 is formed through a known thin film formation process, such as sputtering, ion vacuum deposition, ion plating, and electronic beam evaporation processes. Depending on the electrode material, the thickness of the opposing electrode 4 should enable sufficient injection of electrons into the organic layer 3 and be 0.1 nm or greater and preferably 1 nm or greater. Although there is no upper limit, the upper limit is normally about 5 nm to 1 µm, more preferably about 5 to 1000 nm, further preferably about 10 nm to 500 nm; and most preferably about 50 nm and 200 nm. The electric resistance of the opposing electrode 4 is preferably less than or equal to several hundreds of mm ohms/sheet.

When performing vapor deposition to form the opposing electrode, the conditions for vacuum vapor deposition are not limited. It is however preferred that the degree of vacuum be 10⁻⁴ Pa or less and the vapor deposition rate be about 0.01 to 1 nm/sec.

When the material forming the opposing electrode 4 is the same as the material forming the auxiliary electrode 2, and the vapor deposition conditions, such as the vapor deposition rate, are set appropriately, the organic EL device may be formed using the same vacuum vapor deposition device.

When the opposing electrode 4 and the protective electrode are formed through sputtering, the preferred pressure of the sputtering gas is in the range of 0.1 to 1 Pa. The sputtering gas is inert gas that is used in a normal sputtering device.

When forming the opposing electrode 4 through sputtering, high frequency sputtering or DC sputtering may be performed. It is preferred that the power of the sputtering device be 1 to 10 W/cm² for DC sputtering and 1 to 10 W/cm² for RF sputtering. The film formation rate is preferably 5 to 100 nm/min, and more preferably 10 to 50 nm/min.

The opposing electrode 4 is patterned by performing mask vapor deposition or by performing etching subsequent to the film formation. This separates devices and forms the desired luminescent pattern.

### <Substrate 5>

The substrate 5 is a plate-like member for supporting the organic EL device. The layers of the organic EL device are extremely thin and are thus usually supported by the substrate 5.

The substrate 5 is the member on which the organic EL device is superimposed. It is thus preferable that the substrate has a smooth plane.

When the substrate 5 is located on the light exiting side of the luminescent layer 31, the substrate 5 is transparent.

As long as the substrate 5 has the above functions, any substrate may be used as the substrate 5. Examples of the substrate 5 include glass substrates, silicon substrates, ceramic substrates such as quarts substrates, and plastic substrates. Further, metals substrates or substrates to which a metal layer is applied to the supporting body may be used. A substrate formed by combining a plurality of the same or different substrates may also be used.

### <Modifications>

As described above, the organic EL device of the preferred embodiment needs only to have the requirements listed below:
(1) The organic layer 3 including an organic luminescent layer is held between a pair of electrodes.
(2) At least one of the electrodes is transparent (transparent electrode 1) and the other one of the electrodes is the opposing electrode 4.
(3) The light generated by the organic layer 3 is emitted at least from the transparent electrode 1.
(4) The auxiliary electrode 2 of which resistivity is less than the transparent electrode 1 is arranged between part of the transparent electrode 1 and the organic layer 3.
(5) The surface of the auxiliary electrode 2 that does not contact the transparent electrode 1 or the surface that contacts the organic layer 3 is substantially smooth.

Accordingly, modifications as described below can be made.

### [Smoothing Processes Other than Plasma Processing]

Known smoothing processes such as smoothing through polishing or smoothing through chemical processing may be performed. When employing such smoothing processes, the transparent electrode 1 may be protected to smooth only the auxiliary electrode 2. Alternatively, the transparent electrode 1 may be smoothed together with the auxiliary electrode 2. When performing smoothing in such a manner, the smoothing is performed to satisfy one of the conditions described below to provide an organic EL device having extremely small luminance differences.

Smooth the surface of the auxiliary electrode 2 to 80 nm or less under the ten point height of roughness profile standard. Further, smooth the surface of the auxiliary electrode 2 so that the surface roughness under the ten point height of roughness profile standard is less than or equal to the thickness of the organic layer 3, and preferably 1/1.6 of the thickness of the organic layer 3.

As described above, the lower limit of the surface roughness of the auxiliary electrode 2 under the ten point height of roughness profile standard is not limited. For example, an organic EL device having substantially no luminance differences may be formed even if the ten point height of roughness profile standard is in the range of 20 nm to 80 nm.

Further, when the surface of the auxiliary electrode 2 is set as described above and smoothed to about 1.1 nm to 5.0 nm under the arithmetical mean deviation, a highly satisfactory organic EL device having no luminance differences is formed.

### [Treatment of Auxiliary Electrode 2]

In addition to smoothing, the surface of the auxiliary electrode 2 (especially the surface contacting the organic layer 3) may be treated so that it is oxidized, so that it becomes insulative, or so that it has resistance that is greater than other parts of the auxiliary electrode 2 to decrease power consumption without decreasing the amount of light emitted from the device in comparison to when such treatment is not performed.

The auxiliary electrode 2 may also be transparent. Further, to obtain the necessary luminance, the arrangement of the auxiliary electrode 2 on the transparent electrode 1 may be adjusted and the proportion of the transparent electrode 1 occupied by the auxiliary electrode 2 may be changed to obtain sufficient luminance.

### [Configuration When Transparent Electrode 1 is Cathode]

The transparent electrode 1 may be used as the cathode, and the opposing electrode 4 may be used as the anode. This would obtain the same advantages as the preferred embodiment.

### [Employment of Top Emission Type Configuration]

In the above configuration, the organic EL device is a bottom emission type device in which the transparent electrode 1, the auxiliary electrode 2, the organic layer 3, and the opposing electrode 4 are superimposed one after another on the transparent electrode 5 and in which the light emitted from the organic layer 3 exits from the transparent substrate 5. However, the organic EL device may be a top emission type device in which the opposing electrode 4, the organic layer 3, the auxiliary electrode 2, and the transparent electrode 1 are superimposed one after another on a substrate and in which light exits from the side facing away from the substrate. Further, a configuration in which light exits from opposite sides of the organic layer 3 or other known light exiting configurations may be employed.

### <Examples>

Examples and comparative examples of the present invention will now be described. However, the present invention is not limited to these examples and comparative examples.

### [Example 1]

A transparent electrode 1 (layer made of ITO and having a layer thickness of 220 nm, a width of 4 cm, and a length of 5 cm) was formed on one surface of a glass substrate (substrate 5). The glass substrate was washed by sequentially performing alkali cleaning and pure water cleaning. Then, after being dried, the glass substrate was subjected to ultraviolet ozone cleaning.

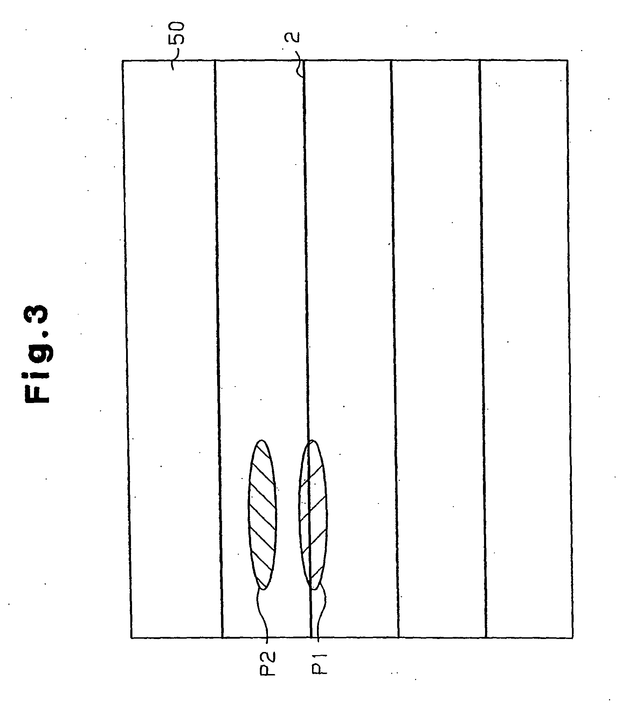

Then, the auxiliary electrode 2 made of Al with a width of 0.3 mm and a thickness of 10 nm was formed by a vacuum vapor deposition device (carbon crucible, deposition .rate: 1 nm/s; degree of vacuum; approximately 5.0 × 10⁻⁵Pa). Fig. 3 shows four auxiliary electrodes 2 spaced at 0.8 cm intervals on the transparent electrode 1. Fig. 3 schematically shows the arrangement of the auxiliary electrodes 2 as viewed from the light exiting surface 50.

After forming the auxiliary electrode 2, plasma processing was performed on the surfaces of the auxiliary electrode 2 that are free from the transparent electrode 1 for ten minutes using Ar and O₂ as a processing gas (the flow rate ratio of Ar and O₂ was 3:1). The AC power used to generate plasma was 200W at a frequency of 13.56 MHz and the operational pressure was 3.6 Pa.

The surface roughness of the surfaces of the auxiliary electrode 2 that were not in contact with the transparent electrode 1 were measured with a roughness meter (manufactured by Shimadzu Corporation, product name SPM-9500J2). The result was 50 nm under the ten point height of roughness profile standard.

After performing the plasma treatment on the auxiliary electrode, a TPTE layer having a thickness of 30 nm was formed on the transparent electrode 1 and the auxiliary electrode 2 by using a vacuum vapor deposition apparatus (carbon crucible, deposition rate: 0.1 nm/s; degree of vacuum: approximately 5.0 × 10⁻⁵Pa). This layer was used as the hole injection transport layer 30. The TPTE is represented by chemical formula 1.

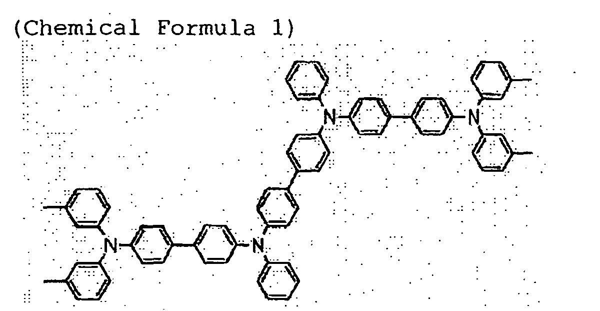

A layer having a thickness of 30 nm was formed on the hole injection transport layer 30 by co-depositing DPVBi (93.0 wt%), which is represented by chemical formula 2, and BCzVBi (7.0 wt%), which is represented by chemical formula 3, using a vacuum vapor deposition device (carbon crucible; deposition rate: 0.1 nm/s; degree of vacuum: approximately 5.0 × 10⁻⁵Pa). This layer was used as the luminescent layer 31.

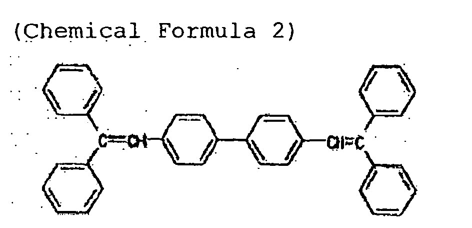

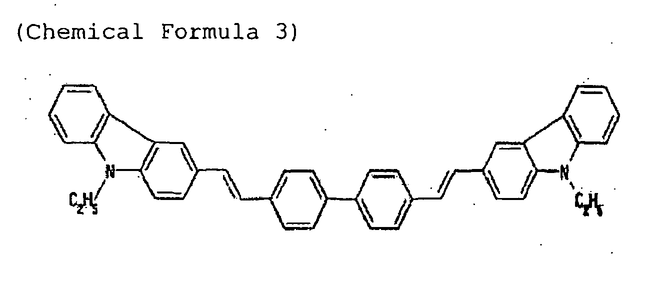

A layer made of 2,5-bis(6'-(2',2"-bipyridyl))-1,1-dimethyl-3,4-diphenylsilole, which is represented by chemical formula 4, was formed on the luminescent layer 31 using a vacuum vapor deposition device (carbon crucible; deposition rate: 0.1 nm/s; degree of vacuum: approximately 5.0 × 10⁻⁵ Pa). The layer was used as the electron injection transport layer 32.

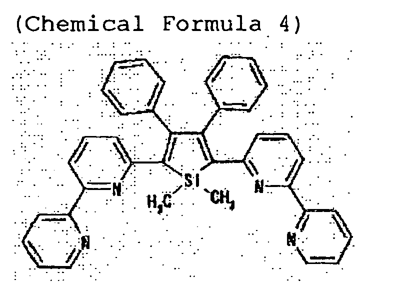

An aluminum layer having a thickness of 150 nm was formed on the electron injection transport layer 32 using a tungsten board (deposition rate: 1 nm/s; degree of vacuum: approximately 5.0 × 10⁻⁵Pa). The layer was used as the opposing electrode 4. This completed the organic EL device.

The organic EL device was sealed by a known passivation film. The transparent electrode 1 and the opposing electrode 4 were connected to a known driving circuit. Then, the number of bright spots produced at a luminance of 1600 cd/m² was visually confirmed. In the light exiting surface 50, the ratio of the luminance near the auxiliary electrode 2 (e.g., portion P1 as shown in Fig. 3) relative to the luminance at portions separated from the auxiliary electrode 2 (e.g., portion P2 as shown in Fig. 3) was measured with a luminance measuring device (manufactured by Topcon Co., product name BM7). The results are shown in table 1.

### [Examples 2 to 7]

In examples 2 to 7, organic EL devices respectively having a surface roughness of 20 nm, 30 nm, 40 nm, 60 nm, 70 nm, and 80 nm under the ten point height of roughness profile standard were formed in the same manner as in example 1 except for the plasma treatment conditions, which were changed to obtain each roughness. The same test as example 1 was conducted on examples 2 to 7. The results are shown in table 1.

### [Comparative Example 1]

In comparative example 1, an organic EL device was manufactured in the same manner as in example 1 except in that the plasma treatment was not performed on the auxiliary electrode 2. The ten point height of roughness profile standard of the surface of the auxiliary electrode 2 was 126.1 nm. The arithmetic means roughness of the surface of the auxiliary electrode 2 was 3.6 nm. The same test as example 1 was conducted on comparative example 1. The results are shown in table 1.

### [Comparative Examples 2 to 5]

In comparative examples 2 to 5, organic EL devices respectively having a surface roughness of 90 nm, 100 nm, 110 nm, and 120 nm under the ten point height of roughness profile standard were formed in the same manner as in example 1 except for the plasma treatment conditions, which were changed to obtain each roughness. The same test as example 1 was conducted on examples 2 to 5. The results are shown in table 1.

**Table 1**

| | Surface Roughness (nm) | Surface Roughness Relative to Thickness of Organic Layer | Number of Bright Spots | Luminance Ratio | Evaluation |
|---|---|---|---|---|---|
| Ex. 1 | 50 | 1 / 1.6 | 0 | 0.98 | ⓞ |
| Ex. 2 | 20 | 1 / 4.0 | 0 | 1.00 | ⓞ |
| Ex. 3 | 30 | 1 / 2.7 | 0 | 1.02 | ⓞ |
| Ex. 4 | 40 | 1 / 2.0 | 0 | 0.99 | ⓞ |
| Ex. 5 | 60 | 1 / 1.3 | 0 | 1.06 | ○ |
| Ex. 6 | 70 | 1 / 1.1 | 0 | 1.08 | ○ |
| Ex. 7 | 80 | 1 / 1.0 | 0 | 1.10 | ○ |
| Comp. Ex. 1 | 126.1 | 1 / 0.63 | 4 | 1.24 | × |
| Comp. Ex. 2 | 90 | 1 / 0.89 | 1 | 1.15 | Δ |
| Comp. Ex. 3 | 100 | 1 / 0.80 | 2 | 1.19 | Δ |
| Comp. Ex. 4 | 110 | 1 / 0.73 | 3 | 1.21 | × |
| Comp. Ex. 5 | 120 | 1 / 0.67 | 4 | 1.23 | × |

### [Evaluation]

It is apparent from examples 1 to 7 and comparative examples 1 to 5 that when the surfaces of the auxiliary electrode 2 free from the transparent electrode 1 have a surface roughness of 20 nm or greater to 80 nm or less, bright spots are not visually confirmed. Further, the luminance ratio between portions near the auxiliary electrode 2 and the other portions was 0.98 to 1.10. Thus, the difference is small and the corresponding organic EL device substantially does not have luminance differences.

However, in the comparative examples, bright spots were confirmed near the auxiliary electrode 2. Further, the luminance ratio between the portion near the auxiliary electrode 2 and other portions exceeded 1.10.

It is also apparent from examples 1 to 7 and comparative examples 1 to 5 that when the surface roughness of the surfaces of the auxiliary electrode 2 free from the transparent electrode 1 is 20 nm or greater to less than 90 nm under the ten point height of roughness profile standard, bright spots are not visually confirmed. Further, the luminance ratio between portions near the auxiliary electrode 2 and the other portions was 0.98 to 1.10. Thus, the difference was small and the corresponding organic EL device substantially did not have luminance differences.

However, in the comparative examples, bright spots were confirmed near the auxiliary electrode 2. Further, the luminance ratio between the portion near the auxiliary electrode 2 and other portions exceeded 1.10.

It is apparent from examples 1 to 7 and comparative examples 1 to 5 that when the surface roughness of the surfaces of the auxiliary electrode 2 free from the transparent electrode 1 has the same thickness of the organic layer 3 or less under the ten point height of roughness profile standard, bright spots are not visually confirmed. Further, the luminance ratio between portions near the auxiliary electrode 2 and the other portions was 0.98 to 1.10. Thus, the difference was small and the corresponding organic EL device substantially did not have luminance differences.

However, in the comparative examples, bright spots were confirmed near the auxiliary electrode 2. Further, the luminance ratio between the portion near the auxiliary electrode 2 and other portions exceeded 1.10.

It is also apparent from examples 1 to 7 and comparative examples 1 to 5 that when the surface roughness of the surfaces of the auxiliary electrode 2 free from the transparent electrode 1 does not exceed 1/0.89 of the thickness of the organic layer 3 under the ten point height of roughness profile standard, bright spots were not visually confirmed. Further, the luminance ratio between portions near the auxiliary electrode 2 and the other portions was 0.98 to 1.10. Thus, the difference was small and the corresponding organic EL device substantially did not have luminance differences.

However, in the comparative examples, bright spots were confirmed near the auxiliary electrode 2. Further, the luminance ratio between the portion near the auxiliary electrode 2 and other portions exceeded 1.10.

The arithmetical mean deviation in examples 1 to 7 was in the range of 0.1 nm or greater to 5.0 nm or less when measured with the roughness meter. However, for other arithmetical mean deviations, the advantages of examples 1 to 7 would also be obtained if the ten point height of roughness profile standard was set in the afore-mentioned range.

It is apparent from examples 1 to 4 that when the surface roughness of the surfaces of the auxiliary electrode 2 free from the transparent electrode 1 is 1/1.6 or less under the ten point height of roughness profile standard, bright spots are not confirmed. Further, the luminance ratio between portions near the auxiliary electrode 2 and the other portions was 0.98 to 1.02. Thus, the difference was extremely small and the corresponding organic EL device substantially did not have luminance differences.

It is apparent from examples 1 to 7 and comparative examples 1 to 5 that when the surface roughness of the surfaces of the auxiliary electrode 2 free from the transparent electrode 1 is less than 1/1.3 under the ten point height of roughness profile standard, bright spots are not confirmed. Further, the luminance ratio between portions near the auxiliary electrode 2 and the other portions was 0.98 to 1.02. Thus, the difference was extremely small and the corresponding organic EL device substantially did not have luminance differences.

It is apparent from examples 1 to 4 that when the surface roughness of the surfaces of the auxiliary electrode 2 free from the transparent electrode 1 is 50 nm or less under the ten point height of roughness profile standard, bright spots are not confirmed. Further, the luminance ratio between portions near the auxiliary electrode 2 and the other portions was 0.98 to 1.02. Thus, the difference was extremely small and the corresponding organic EL device substantially did not have luminance differences.

It is apparent from examples 1 to 7 and comparative examples 1 to 5 that when the surface roughness of the surfaces of the auxiliary electrode 2 free from the transparent electrode 1 is less than 60 nm under the ten point height of roughness profile standard, bright spots were not confirmed. Further, the luminance ratio between portions near the auxiliary electrode 2 and the other portions was 0.98 to 1.02. Thus, the difference was extremely small and the corresponding organic EL device substantially did not have luminance differences.

Further, it is apparent from examples 1 to 7 and comparative examples 1 to 5 that when the surface roughness of the surfaces of the auxiliary electrode 2 free from the transparent electrode 1 is in the ranges described below, the luminance ratio between portions near the auxiliary electrode 2 and the other portions is 1.19 or less. Further, only a small number of bright spots (maximum two) were visually controlled near the auxiliary electrode 2.
* greater than 80 nm and less than 110 nm
* 90 nm or greater and 100 nm or less
* greater than 80 nm and 100 nm or less
* 90 nm or greater and less than 110 nm
* 1/0.89 or greater and 0.80 or less of the thickness of the organic layer 3
* less than 1/1 and 0.80 or less of the thickness of the organic layer 3
* 1/0.89 or greater and greater than 1/0.73 of the thickness of the organic layer 3
* less than 1/1 and greater than 1/0.73 of the thickness of the organic layer 3

Accordingly, the present invention provides an organic EL device in which the luminance is substantially the same throughout the light exiting surface 50 and in which bright spots are not produced near the auxiliary electrodes 2. Thus, the organic EL device has substantially no luminance differences.

It should be apparent to those skilled in the art that the present invention may be embodied in many other specific forms without departing from the spirit or scope of the invention. Therefore, the present examples and embodiments are to be considered as illustrative and not restrictive, and the invention is not to be limited to the details given herein, but may be modified within the scope and equivalence of the appended claims.
An organic EL device having uniform brightness. The organic EL device includes two electrodes (1, 4), one of which is transparent. An organic layer (3) including organic electroluminescent material is arranged between the two electrodes. The organic layer emits light that exits from the transparent electrode. An auxiliary electrode (4) is arranged between the transparent electrode and the organic layer. The auxiliary electrode has resistivity that is less than that of the transparent electrode and includes a first surface that is in contact with the transparent electrode and a second surface that does not contact the transparent electrode and has been plasma-treated.

## Claims

1. An organic electroluminescent device provided with two electrodes (1, 4), at least one (1) of which is transparent, an organic layer (3) including organic electroluminescent material and arranged between the two electrodes, the organic layer being operable for emitting light that exits from the transparent electrode, and an auxiliary electrode (2) arranged between the transparent electrode and the organic layer, the auxiliary electrode having resistivity that is less than that of the transparent electrode, the organic electroluminescent device being **characterized by**:
a first surface that is in contact with the transparent electrode and a second surface that does not contact the transparent electrode and that has been plasma-treated.

2. The organic electroluminescent device according to claim 1, **characterized in that** the second surface of the auxiliary electrode has a roughness that is 80 nm or less under the ten point height of roughness profile standard.

3. The organic electroluminescent device according to claim 1 or 2, **characterized in that** the organic layer has a predetermined thickness, and the second surface of the auxiliary electrode has a roughness that is less than the thickness of the organic layer under the ten point height of roughness profile standard.

4. The organic electroluminescent device according to any one of the preceding claims, **characterized in that** the auxiliary electrode is transparent.

5. The organic electroluminescent device according to any one of the preceding claims, **characterized in that** the auxiliary electrode has a transmittance of 80% or greater.

6. The organic electroluminescent device according to any one of the preceding claims, **characterized in that** the second surface of the auxiliary electrode is insulative.

7. The organic electroluminescent device according to any one of the preceding claims, **characterized in that** the second surface of the auxiliary electrode has a resistance that is greater than that of the first surface.

8. The organic electroluminescent device according to any one of the preceding claims, **characterized in that** 50% or more of the second surface of the auxiliary electrode is plasma-treated.

9. The organic electroluminescent device according to any one of the preceding claims, **characterized in that** the auxiliary electrode is formed from a material including aluminum:

10. A method for manufacturing an electroluminescent device including two electrodes, at least one of which is transparent, and an organic layer arranged between the two electrodes, the method including forming an auxiliary electrode on the transparent electrode, the auxiliary electrode having resistivity that is less than that of the transparent electrode and having a first surface that is in contact with the transparent electrode and a second surface that does not contact the transparent electrode, the method being **characterized by**:
plasma-treating at least part of the second surface of the auxiliary electrode; and
superimposing the organic layer and the other one of the electrodes on the transparent electrode and the auxiliary electrode.

11. The method according to claim 10, **characterized in that** said plasma-treating includes plasma-treating the auxiliary electrode in an environment in which oxygen exists.

12. The method according to claim 10 or 11, **characterized in that** said plasma-treating includes using a gas containing argon and oxygen.

13. The method according to any one of claims 10 to 12, **characterized in that** the second surface of the auxiliary electrode has a roughness, said plasma-treating includes smoothing the second surface of the auxiliary electrode so that the roughness of the second surface becomes 80 nm or less under the ten point height of roughness profile standard.

14. The method according to any one of claims 10 to 13, **characterized in that** the organic layer has a predetermined thickness and the second surface of the auxiliary electrode has a roughness, said plasma-treating includes smoothing the second surface of the auxiliary electrode so that the roughness of the second surface becomes less than the thickness of the organic layer under the ten point height of roughness profile standard.
